# EUROPEAN PATENT APPLICATION

(11) **EP 2 100 985 A1**
(43) Date of publication of application: **16.09.2009**
(21) Application number: 09001334.3
(22) Date of filing: 30.01.2009
(51) Int. Cl.: C23C 14/06, C23C 28/00, C23C 30/00

(54) **Hard film for cutting tool**

(30) Priority: 31.01.2008 JP 2008021787
(71) Applicant: UNION TOOL CO., Tokyo (JP)
(72) Inventor: Sato, Akira, Tokyo (JP); Kawamura, Kazuhiro, Tokyo (JP); Yamaya, Takanori, Tokyo (JP)
(74) Representative: Kramer - Barske - Schmidtchen

(57) **Abstract**

A hard film is provided having excellent abrasion resistance in cutting high hardness quenched steel. There is provided a hard film for a cutting tool that is to be formed on a base material, wherein the hard film has a multilayered film layer formed by alternately layering two or more layers each of a first film layer and a second film layer; the first film layer is a film layer that contains at least Al and Cr as metal components, N as a non-metal component, and unavoidable impurities; the second film layer is a film layer that contains at least Ti and Si as metal and semimetal components, N as a non-metal component, and unavoidable impurities; the thickness of each of the first film layers and the second film layers is set to 1 nm or more and 20 nm or less; and the second film layer has a mixed structure of an amorphous part and granular micro crystals having an average particle diameter of 1 nm or more and 20 nm or less, wherein 10 or more micro crystals of the second film layer penetrate into the adjacent first film layer to a depth of 10% or more of the thickness of the first film layer in an area of 1 µm × 1 µm when the multilayered film layer is observed using a cross section TEM method.

## Description

### TECHNICAL FIELD

The present invention relates to a hard film for a cutting tool for coating a tool used for cutting or otherwise machining high hardness steel.

### BACKGROUND ART

Conventionally, TiN, TiCN, or TiAlN has been used as a hard abrasion-resistant film for coating a metal cutting tool. In particular, a TiAlN-based film typified by Patent Documents 1 and 2 has improved hardness and abrasion resistance by the addition of Al to TiN, and, based on its abrasion resistance, is widely used as a hard film for a cutting tool for machining steel material, including quenched steel.

However, there is a need in recent years for a tool that can cut material having even higher hardness, and a hard film for a cutting tool such as that disclosed in Patent Documents 3 and 4 has been proposed in which a TiAlN-based film and a TiSiN-based film are layered.

[Patent Document 1] Japanese Laid-open Patent Application No. 62-56565
[Patent Document 2] Japanese Laid-open Patent Application No. 2-194159
[Patent Document 3] Japanese Patent No. 3248897
[Patent Document 4] Japanese Patent No. 3248898

However, with the cutting of high hardness quenched steel typified by SKD11 or the like, abrasion resistance cannot be said to be sufficient even using the Si-containing multilayered film of the prior arts, and there is a need to develop a hard film for a cutting tool in which abrasion-resisting performance is improved.

### DISCLOSURE OF THE INVENTION

The present invention was contrived in view of the current circumstances as described above, and as a result of research related to film structure, film layer configuration, and film composition in a hard film for a cutting tool, the present inventors perfected the present invention having found that the problems described above can be solved by adjusting the film structure, the film layer configuration, and the film composition; and an object of the present invention is to provide a hard film for a cutting tool that has very good practicality and in which abrasion resistance is improved in the cutting high hardness quenched steel typified by SKD11 or the like in comparison with a conventional hard film for a cutting tool.

The main points of the present invention are described below.

The present invention is a hard film for a cutting tool that is to be formed on a base material, the hard film for a cutting tool **characterized in that** the hard film has a multilayered film layer formed by alternately layering two or more layers each of a first film layer and a second film layer; the first film layer is a film layer that contains at least Al and Cr as metal components, N as a non-metal component, and unavoidable impurities; the second film layer is a film layer that contains at least Ti and Si as metal and semimetal components, N as a non-metal component, and unavoidable impurities; the thickness of each of the first film layers and the second film layers is set to 1 nm or more and 20 nm or less; and the second film layer has a mixed structure of an amorphous part and granular micro crystals having an average particle diameter of 1 nm or more and 20 nm or less, wherein 10 or more micro crystals of the second film layer penetrate into the adjacent first film layer to a depth of 10% or more of the thickness of the first film layer in an area of 1 µm × 1 µm when the multilayered film layer is observed using a cross section TEM method.

The present invention is also a hard film for a cutting tool that is to be formed on a base material, the hard film for a cutting tool **characterized in that** the hard film has a multilayered film layer formed by alternately layering two or more layers each of a first film layer and a second film layer; the thickness of each layer of the first film layer and the second film layer is set to 1 nm or more and 20 nm or less; the first film layer has metal and semimetal components that are expressed as Al_{(100-x-y-2)}Cr₍ₓ₎V_{(y)}B_{(z)} in terms of at%, wherein 20 ≤ x ≤ 40, 2 ≤ y ≤ 15, 2 ≤ z ≤ 15, and has N as a nonmetal component as well as unavoidable impurities; and the second film layer has metal and semimetal components that are expressed as Ti_{(100-v-w)} Cr₍ᵥ₎Si_{(w)} in terms of at%, wherein 5 ≤ v ≤ 30, 5 ≤ w ≤ 30, and has N as a nonmetal component as well as unavoidable impurities.

In the hard film for a cutting tool according to the first aspect, the hard film for a cutting tool is **characterized in that** a third film layer is disposed between the base material and the multilayered film layer; and the metal component of the third film layer is the same as the metal component of the first film layer.

In the hard film for a cutting tool according to the second aspect, the hard film for a cutting tool is **characterized in that** a third film layer is disposed between the base material and the multilayered film layer; the metal component and the semimetal component of the third film layer are the same as the metal component and the semimetal component of the first film layer.

In the hard film for a cutting tool according to the third aspect, the hard film for a cutting tool is **characterized in that** a fourth film layer is disposed directly on the base material; the fourth film layer is composed of a nitride or a carbonitride in which Ti is a main component; and a thickness of the fourth film layer is set to 0.01 µm to 0.5 µm.

In the hard film for a cutting tool according to the fourth aspect, the hard film for a cutting tool is **characterized in that** a fourth film layer is disposed directly on the base material, the fourth film layer is composed of a nitride or a carbonitride in which Ti is a main component; and a thickness of the fourth film layer is set to 0.01 µm to 0.5 µm.

In the hard film for a cutting tool according to the third aspect, the hard film for a cutting tool is **characterized in that** a fourth film layer is disposed directly on the base material; the fourth film layer is composed of a nitride or a carbonitride in which Cr is a main component; and a thickness of the fourth film layer is set to 0.01 µm to 0.5 µm.

In the hard film for a cutting tool according to the fourth aspect, the hard film for a cutting tool is **characterized in that** a fourth film layer is disposed directly on the base material; the fourth film layer is composed of a nitride or a carbonitride in which Cr is a main component; and a thickness of the fourth film layer is set to 0.01 µm to 0.5 µm.

In the hard film for a cutting tool according to any one of the first to eighth aspects, the hard film for a cutting tool is **characterized in that** a fifth film layer is disposed on the surface layer side of the multilayered film layer; and the metal component and the semimetal component of the fifth film layer are the same as the metal component and semimetal component of the second film layer.

In the hard film for a cutting tool according to any one of the first to eighth aspects, the hard film for a cutting tool is **characterized in that** a fifth film layer is disposed on the surface layer side of the multilayered film layer; and the metal component, or the metal component and the semimetal component of the fifth film layer are the same as the metal component, or the metal component and semimetal component of the first film layer.

In the hard film for a cutting tool according to the ninth aspect, the hard film for a cutting tool is **characterized in that** the base material is a superhard alloy composed of hard particles in which-WC is a main component and a binding material having Co as a main component, wherein the average diameter of the WC particles is set to 0.1 µm to 2 µm, and a content of Co by wt% is 5 to 15%.

In the hard film for a cutting tool according to the tenth aspect, the hard film for a cutting tool is **characterized in that** the base material is a superhard alloy composed of hard particles in which WC is a main component and a binding material having Co as a main component, wherein the average diameter of the WC particles is set to 0.1 µm to 2 µm, and a content of Co by wt% is 5 to 15%.

In accordance with the configuration as described above, the present invention is a hard film for a cutting tool that has very good practicality and in which interlayer adhesiveness between the first film layer and the second film layer is increased, and abrasion resistance is improved in the cutting high hardness quenched steel typified by SKD11 or the like in comparison with a conventional hard film for a cutting tool.

### BRIEF DESCRIPTION OF THE DRAWINGS

FIG. 1 is a schematic cross-sectional view of the multilayered film layer of the present example; and
FIG. 2 is an enlarged schematic cross-sectional view of the multilayered film layer of the present example.

### BEST MODE FOR CARRYING OUT THE INVENTION

Preferred embodiments of the present invention are briefly described below while indicating the effects of the present invention.

Micro crystals of a second film layer penetrate and bite into a first film layer in the manner of a wedge, whereby interlayer adhesiveness between the first film layer and the second film layer is increased, and abrasion resistance in relation to high hardness quenched steel typified by SKD11 or the like is enhanced by a commensurate amount.

### Examples

Specific examples of the present invention will be described with reference to the drawings.

The present example is a hard film for a cutting tool that is to be formed on a base material, **characterized in that** the hard film has a multilayered film layer formed by alternately layering two or more layers each of a first film layer and a second film layer; the first film layer is a film layer that contains at least Al and Cr as metal components, N as a non-metal component, and unavoidable impurities; the second film layer is a film layer that contains at least Ti and Si as metal and semimetal components, N as a non-metal component, and unavoidable impurities; the thickness of each layer of the first film layer and the second film layer is set to 1 nm or more and 20 nm or less; and the second film layer has a mixed structure of an amorphous part and granular micro crystals having an average particle diameter of 1 nm or more and 20 nm or less, wherein 10 or more micro crystals of the second film layer penetrate into the adjacent first film layer to a depth of 10% or more of the thickness of the first film layer in an area of 1 µm × 1 µm when the multilayered film layer is observed using a cross section TEM method.

Each component will be described in detail.

A base material is adopted that is made of a superhard alloy composed of hard particles having WC (tungsten carbide) as a main component and a binding material having Co (cobalt) as a main component. Specifically, a base material is adopted which the average diameter of the WC particles is set to 0.1 µm to 2 µm, and the Co content by wt% is 5 to 15%.

A fourth film layer composed of a nitride or a carbonitride in which Ti (titanium) is a main component is disposed directly on the base material. The thickness of the fourth film layer is set to 0.01 µm to 0.5 µm. The fourth film layer may be composed of a nitride or a carbonitride in which Cr (chromium) is a main component. The thickness may be set to 0.01 µm to 0.5 µm in this case as well.

A third film layer is disposed on the fourth film layer. The metal component, or the metal component and the semimetal component of the third film layer is set to be the same as the metal component, or the metal component and the semimetal component of the first film layer. In the present example, the first film layer has a configuration that includes a metal component and a semimetal component, described below, and the metal component and a semimetal component of the third film layer is set to be the same as the metal component and a semimetal component of the first film layer.

In the present example, a multilayered film layer is provided which is formed by alternately layering the first film layer and the second film layer on the third film layer.

The first film layer has a configuration in which the metal and semimetal components are expressed as Al_{(100-x-y-z)}Cr₍ₓ₎V_{(y)}B_{(z)} in terms of at%, wherein 20 ≤ x ≤ 40, 2 ≤ y ≤ 15, 2 ≤ z ≤ 15, and has N as a nonmetal component as well as unavoidable impurities.

The second film layer has a configuration in which the metal and semimetal components are expressed as Ti_{(100-v-w)}Cr₍ᵥ₎Si_{(w)} in terms of at%, wherein 5 ≤ v ≤ 30, 5 ≤ w ≤ 30, and has N as a nonmetal component as well as unavoidable impurities.

A fifth film layer is disposed on the surface layer of the multilayered film layer, and the metal components, semimetal components, and nonmetal components of the fifth film layer are set to be the same as the metal components, semimetal components, and nonmetal components of the second film layer. The metal components, semimetal components, and nonmetal components of the fifth film layer may be set to be the same as the metal components, semimetal components, and nonmetal components of the first film layer.

The reason for adopting the above-described configuration and the effects of the configuration are described below.

First, the characteristics and problems of an Al-Cr-N-based film and Ti-Si-N-based film will be described. The Al-Cr-N film proposed in Patent No. 3039381 and the like improves heat resistance by using CrN in place of TiN as a base in a Ti-Al-N film, which is conventionally widely used as a hard film for a cutting tool. Although heat resistance is high and toughness is also relatively high, the hardness is somewhat low and abrasion resistance cannot be said to be sufficient for cutting high hardness quenched steel typified by SKD11 and the like. On the other hand, according to Veprek, et al. (S. Christiansen, M. Albrecht, H.P. Strunk, and S. Veprek, J. Vac. Sci. Technol. B16(1), Jan/Feb 1998), it is said that Ti-Si-N film has a mixed structure of granular TiN microcrystals and a Si-N non-crystalline part, and is a film in which very high hardness can be obtained and abrasion resistance is high. However, although hardness and heat resistance is high, toughness is somewhat low, and there are cases in which the blade undergoes micro chipping when a high hardness workpiece material is cut. The present inventors carried out research with the concept of layering a thin layer of an Al-Cr-N-based film and a thin layer of a Ti-SiN-based film, whereby the deficiencies of the two films can be offset and abrasion resistance in relation to a high hardness workpiece material can be increased.

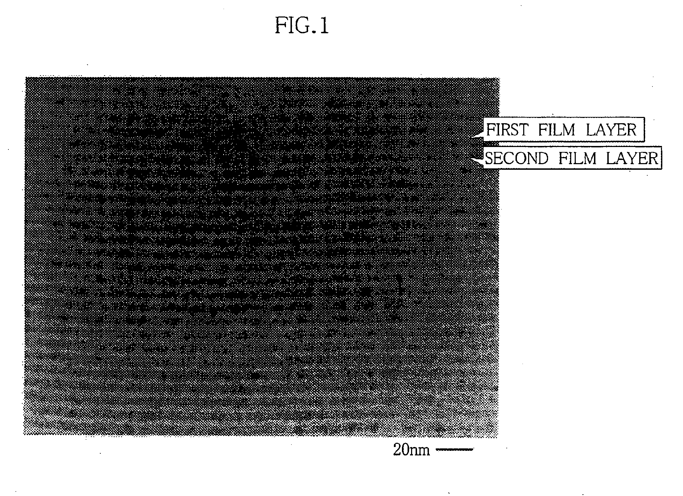

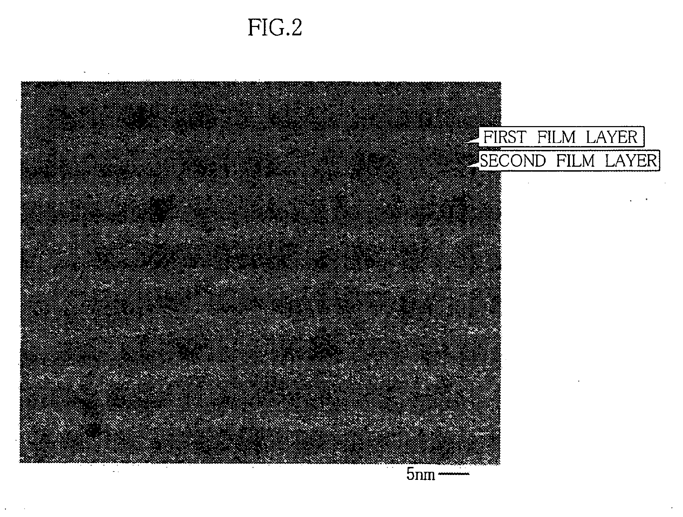

The present inventors fabricated a film under various film formation conditions and performed research related to the layered films of an Al-Cr-N-based film layer and a Ti-Si-N-based film layer, and found that the quality of interlayer adhesiveness inside the film layering part greatly affects the abrasion resistance of the coated tool. In other words, good abrasion resistance can be obtained in relation to a high hardness workpiece material, when the interlayer adhesiveness inside the film layering part is good. However, the tool becomes abraded in accompaniment with micro chipping when interlayer adhesiveness is poor, and sufficient abrasion resistance cannot be obtained. It is surmised that the latter coated tool undergoes micro damage inside the layered part, and tool abrasion increases about the micro damage as a starting point. When the layered part was observed using the cross section TEM method, a portion of the microcrystals inside the Ti-Si-N-based film layer was found to bite into the adjacent Al-Cr-N-based film layer in a film having good abrasion resistance. The microcrystals bite into the adjacent layer, whereby the adhesiveness between the layers inside the film-layered part is improved and, as a result, good abrasion resistance is achieved in the coated tool. Based on these results, in the present example, a multilayered hard film for a cutting toll having excellent abrasion resistance is provided in which the adhesiveness of interlayer inside the film-layered part is increased by controlling the film structure so that a portion of the microcrystals inside the Ti-Si-N-based film layer are made to bite into the adjacent Al-Cr-N-based film layer. Since the adhesiveness of the interlayer cannot be made sufficiently high when the number of biting microcrystals is low or when the depth of the bite is low, it is preferred that 10 or more microcrystals of the second film layer bite into the adjacent first film layer at a depth of 10% or higher of the thickness of the first film layer in a surface area of 1 µm × 1 µm when the layered part (multilayered film layer) is observed using the cross section TEM method. In said cross section TEM method the film was observed in a direction substantially at a right angle to the growth direction of the film by using a transmission electron microscope (TEM), in order to confirm the growth-direction structure of the hard film grown on the substrate. In particular, in the examples described further below, a model H-9000UHR TEM (manufactured by Hitachi) was used, the acceleration voltage was set to 300 kV, the film was observed and photographed at a magnification of x 3,000,000, and the size (mean grain size) of microcrystals was determined based on the photographs taken. In particular, the mean grain size was determined by measuring the longest extension of each grain in the image plane and calculating the mean value of all measuring values. Examples of the photographs are shown in Figs. 1 and 2. Systematic research must be carried out in the future in relation to the film formation conditions in which the phenomenon occurs in which the microcrystals bite into the adjacent layer, and the film formation temperature and the energy of the film-forming particles are thought to have considerable affect.

Next, the thickness of each layer of the first film layer and the second film layer will be described. When the thickness per layer is less than 1 nm, the microcrystals inside the second film layer are less likely to be generated, and a mixed structure of the microcrystals and non-crystal parts is less likely to be obtained. On the other hand, the second film layer becomes excessively thick and the toughness of the layered film overall cannot be made sufficiently high when the thickness of each layer is greater than 20 nm. Also, when the first film layer is excessively thin, the toughness of the entire layered film is not high, and when the first film layer excessively thick, the hardness of the layered film overall is reduced. In accordance with the above, it is preferred that the thickness of each layer of the first film layer and the second film layer be 1 nm or more and 20 nm or less.

The average particle diameter of the microcrystals in the second film layer will be described next. When the average particle diameter is excessively great, the microcrystals are more liable to plastically deform and the hardness of the film is reduced. On the other hand, when the average particle diameter is excessively small, the surface area of the microcrystals becomes excessively great and the non-crystal part is less able to be stably dispersed between the crystal grains. For this reason, it is preferred that the value of the average particle diameter of the microcrystals be 1 nm or more and 20 nm or less.

The composition of the first film layer will be described next. The present example is a composition that lies within the range of the invention, includes at least Al and Cr as metal and semimetal components, includes N as a nonmetal component, and has AlCrN as a base. The present inventors studied a film having various ternary additions to the AlCrN film, and found that abrasion resistance in relation to steel material can be improved by including V and B in predetermined amounts. This is thought to be due to an improvement in the hardness and lubricity of the film. The effect is small when the B content is less than 2% in terms of at% of only the metal and semimetal components, but an effect of improved hardness is manifest at 2% or higher. The value of the hardness varies very little when the B content exceeds 15%. Since B is a very expensive element in comparison with Al and Cr, it is preferred that B be included in a composition range of 2% or more and 15% or less in terms of at% of only the metal and semimetal components when consideration is given to film hardness and economical efficiency. Lubricity of the film is improved when the V content is high. The effect is low when the amount of V is less than 2% in terms of at% of only the metal and semimetal components, but an effect of improved lubricity is manifest at 2% or higher, and abrasion resistance of the film coated tool is improved in relation to steel material. On the other hand, the hardness of the film is reduced when the V content is excessively high and abrasion resistance in relation to steel material is reduced. Also, Since V is a very expensive element in comparison with Al and Cr, it is preferred that V be included in a composition range of 2% or more and 15% or less in terms of at% of only the metal and semimetal components when consideration is given to the lubricity and hardness of the film as well as economical factors.

Next, the composition of the second film layer will be described. The present example is one that includes at least Ti and Si as metal and semimetal components, includes N as a nonmetal component, and has TiSiN as a base. The present inventors tested various types of ternary additions in order to further improve the abrasion resistance of the film using TiSiN as a base. As a result, it was confirmed that lubricity and abrasion resistance of the film is improved when Cr is added in a predetermined amount. In other words, the effect is small when the Cr content is less than 5% in terms of at% of only the metal and semimetal, but an effect of improved lubricity is manifest at 5% or higher and it was confirmed that the abrasion resistance of the film-coated superhard alloy base material cutting tool is improved in relation to a high hardness workpiece material. It was confirmed that the hardness of the film is reduced when the Cr content is excessively high and abrasion resistance of the film-coated superhard alloy base material cutting tool is reduced in relation to a high hardness workpiece material. Based on these facts, it is preferred that the Cr content be 5% or more and 30% or less in terms of at% of only the metal and semimetal. On the other hand, when the Si content is increased, the oxidation resistance and hardness of the film is improved. In other words, the effect is small when the Si content is less than 5% in terms of at% of only the metal and semimetal, but an effect of improved oxidation resistance and hardness is manifest at 5% or higher, and it was confirmed that the abrasion resistance of the film-coated superhard alloy base material cutting tool is improved in relation to a high hardness workpiece material. When the Si content is insufficient, it is surmised that the ratio of the non-crystal part in the second film layer is low and the non-crystal part is less able to be stably dispersed between the crystal grains. It was also confirmed that when the Si content is excessively high, abrasion resistance of the film-coated superhard alloy base material cutting tool is reduced in relation to a high hardness workpiece material. This is thought to be due to the fact that internal stress of film is increased when the Si content is excessively high, and micro-fractures in the film are readily generated when the ratio of the non-crystal part in the second film layer is excessively high. Based on these facts, it is preferred that the Si content be 5% or more and 30% or less in terms of at% of only the metal and semimetal.

The third film layer will be described next. The present inventors coated a multilayered film layer on a cutting tool made of a superhard alloy and carried out a cutting test, and confirmed that there are cases in which the film peels during cutting. It is thought that adhesiveness between the superhard alloy base material and the film is insufficient. In view of the above, the third film layer was formed between the superhard alloy base material and the multilayered film layer, and the metal and semimetal components of the third film layer were given the same composition as the metal component and the semimetal component of the first film layer, whereupon the film peeling during cutting was considerably reduced. It is surmised that adhesiveness between the superhard alloy base material and the film is greatly improved by having formed a third film layer. The thickness of the third film layer is not particularly limited, but it is preferred that the thickness be 0.1 µm or more because the effect of improving adhesiveness is less liable to occur when the third film layer is excessively thin.

A Ti-based or Cr-based nitride or carbonitride (fourth film layer) having excellent adhesiveness with the base material may be formed directly on the base material as another method for reducing film peeling. Film peeling can be considerably reduced even if a fourth film layer is formed directly on the base material and a multilayered film layer is formed on the fourth film layer. A more preferred film configuration in one in which the fourth film layer is formed directly on the base material, the third film layer is formed on the fourth film layer, and a multilayered film layer is then formed on the third film layer. The effect of improving the adhesiveness with the base material is manifest even if the thickness of the fourth film layer is comparatively low in the case that the third film layer is formed on the fourth film layer. However, it is preferred that the thickness be 0.01 µm or more even in such a case. Also, since the purpose of the fourth film layer is to obtain the effect of improved adhesiveness with the base material, the thickness of the film is not required to be excessively great and it is preferred that the thickness be 0.5 µm or less.

The fifth film layer will be described next. The present inventors confirmed that there are cases in which abrasion resistance of the coated tool is slightly further improved depending on the type of material to be cut by forming an Al-Cr-N-based film (the metal and semimetal components have the same composition as the first film layer) or the Ti-Si-N-based film (the metal and semimetal components have the same composition as the second film layer) on the topmost layer part. The abrasion resistance of the coated tool is somewhat improved in relation to SKD11 material heat-treated to 60 HRC, by forming the Ti-Si-N-based film on the topmost part. On the other hand, the abrasion resistance of the coated tool is somewhat improved in relation to STAVAX material heat-treated to 53 HRC, by forming the Al-Cr-N-based film on the topmost part. As described above, the Al-Cr-N-based film is **characterized in that** the toughness is relatively high, but the hardness is somewhat low; and the Ti-Si-N-based film is **characterized in that** the hardness is high, but the toughness is somewhat low. Although the specific mechanism is unknown, it is thought that these characteristics bring about a good effect in abrasion resistance of the coated tool when the fifth film layer is disposed on the topmost part. The thickness of the fifth film layer is not particularly limited, but it is preferred that the thickness be 0.1 µm or more and 1 µm or less because the effects are less likely to be made manifest when the thickness is excessively low, and reduced hardness (Al-Cr-N-based film) or reduced toughness (Ti-Si-N-based film) is made manifest when the thickness is excessively great.

The hard film of the present example was invented for a steel material cutting tool, but it is preferred that the superhard alloy composed of hard particles having WC as a main component and a binding material having Co as a main component be used as the base material, and be a material having a balance between hardness and toughness as the steel material cutting tool. When the average diameter of the WC particles is excessively small, the WC particles are less likely to be uniformly dispersed in the binding material, and the transverse rupture strength of the superhard alloy is readily reduced. On the other hand, the hardness of the superhard alloy is reduced when the WC particles are excessively large. Also, the transverse rupture strength of the superhard alloy is reduced when the Co content is excessively low, and conversely, the hardness of the superhard alloy is reduced when the Co content is excessively great. For this reason, it is preferred that the average diameter of the WC particles be 0.1 µm to 2 µm, and that the superhard alloy having a Co content of 5 to 15% in terms of wt% be used as the base material.

The present example, having the configuration described above, is one in which the microcrystals of the second film layer penetrate and bite into the first film layer in the manner of a wedge, whereby the interlayer adhesiveness between the first film layer and the second film layer is increased and abrasion resistance in relation to high hardness quenched steel typified by SKD11 is improved by a commensurate amount.

In particular, in the present example, a fourth film layer, a third film layer, a multilayered film layer, and a fifth film layer are sequentially layered on a base material, and a film layer having predetermined characteristics is furthermore formed on the base material and the surface layer of the multilayered film layer. In other words, a film layer having excellent toughness is disposed on the base material side of the film in which film stress becomes considerable, and a film layer having excellent hardness is disposed on the surface layer that is in contact with the workpiece, whereby the film is less likely to peel away from the base material, the surface layer is less liable to abrade, and the liability of chipping is considerably reduced.

Therefore, the present example is a hard film for a cutting tool in which interlayer adhesiveness between the first film layer and the second film layer is improved, and that has very good practicality in that abrasion resistance is improved by a commensurate amount in the cutting of high hardness quenched steel typified by SKD11 or the like in comparison with a conventional hard film for a cutting tool.

Examples that confirm the effect of the present invention are described below.

### [Example 1]

In example 1, an arc-discharge ion plating apparatus was used as a film formation apparatus, and Al₆₀Cr₂₇V₅B₈ and Ti₆₂Cr₁₅Si₂₃ targets were mounted in the film formation apparatus as vapor sources of the metal and semimetal components. Also, N₂ gas as a reaction gas was introduced inside the film formation apparatus, the gas pressure was set to 3 Pa, the bias voltage was set to - 300 V, the base material temperature was set to 550°C, and a superhard alloy plate was formed as a film formation base material. The two types of targets were disposed so as to face each other inside the film formation apparatus, and the film formation base material was set in the center part of the apparatus and made to rotate at a rotational speed of 3 min⁻¹ (the rotational axis was parallel to the target surface). The (Al₆₀Cr₂₇V₅B₈)N (first film layer) and the (Ti₆₂Cr₁₅Si₂₃)N (second film layer) were alternately layered on the super hard alloy plate in accompaniment with the rotation.

The example of a film formed in the manner described above was observed using the cross section TEM method, and the results are shown in FIGS. 1 and 2. FIG. 2 shows a portion of FIG. 1 enlarged. In FIGS. 1 and 2, the layer that appears relatively black is the second film layer, and the layer that appears relatively white is the first film layer. It can be confirmed from the TEM image that the second film layer has a mixed structure of granular microcrystals and non-crystal parts. When the microcrystals of the second film layer are viewed in detail, it can be confirmed that there are microcrystals biting into the first film layer. The interlayer adhesiveness of the multilayered film layer can be considerably improved by ensuring that the microcrystals of the second film layer bite into the adjacent first film layer, and abrasion resistance of a coated tool is thereby be improved.

### [Example 2]

In example 2, an arc-discharge ion plating apparatus was used as a film formation apparatus, and targets having various compositions were mounted in the film formation apparatus as vapor sources of the metal and semimetal components. Also, one or two types of gases from among N₂ gas and CH₄ gas were introduced as reaction gases inside the film formation apparatus, and a predetermined film was formed on a ball end mill (outside diameter: 3 mm) composed of a superhard alloy and having two blades as a film formation base material. A film formation apparatus in which three types of targets could be mounted was used, two or three types of targets were mounted, film formation was carried out. During film formation, the gas pressure was set to 3 Pa, the bias voltage was set to -50 to -300 V, the base material temperature was set to 300°C to 550°C, and a film was formed on the base material end mill to a thickness for all the films of 3.0 to 4.0 µm. The end mill coated with a predetermined film was subjected to a cutting test under the following conditions and the abrasion width of the end mill flank surface was measured. In other words, a test was carried out in which the workpiece material was SKD11 quenched material (60 HRC), the end mill having an outside diameter of 3 mm was rotated at a rotational speed of 19000 min⁻¹, the feed speed was 1440 mm/min, the cutting distance was Ad = 0.15 mm and Pf = 0.45 mm, and air blowing was used as a coolant. The results of the cutting test are shown in TABLE 1.

**TABLE 1**

| No | Fourth film layer | | Third film layer | | Multilayer film layer | | Fifth film layer | | Abrasion width of the flank (mm) | Remarks |
|---|---|---|---|---|---|---|---|---|---|---|
| | Composition | Thickness (µm) | Composition | Thickness (µm) | Composition | Thickness (µm) | Composition | Thickness (µm) | | |
| 1 | TiN | 0.2 | (Al₆₀Cr₂₇V₅B₈) N | 1.5 | (Al₆₀Cr₂₇V₅B₈)N, (Ti₆₂Cr₁₅Si₂₃) N | 1.5 | (Ti₆₂Cr₁₅Si₂₃) N | 0.3 | 0.038 | Example |
| 2 | TiN | 0.3 | (Al₅₃Cr₃₂V₅B₁₀) N | 1.5 | (Al₅₃Cr₃₂V₅B₁₀)N, (Ti₈₀Si₂₀) N | 1.5 | (Ti₈₀Si₂₀) N | 0.3 | 0.052 | Example |
| 3 | - | - | (Al₆₀Cr₂₇V₅B₈)N | 1.7 | (Al₆₀Cr₂₇V₅B₈)N, (Ti₈₀Si₂₀)N | 1.8 | - | - | 0.065 | Example |
| 4 | TiN | 0.4 | - | - | (Al₆₀Cr₂₇V₅B₈)N, (Ti₆₂Cr₁₅Si₂₃) N | 3 | - | - | 0.108 | Example |
| 5 | TiN | 0.2 | (Al₆₅Cr_{3S})N | 1.5 | (Al₆₅Cr₃₅)N, (Ti₆₆Cr₂₃Si₁₁)N | 1.8 | - | - | 0.104 | Example |
| 6 | TiN | 0.2 | (Al₆₀Cr₂₇V₅B₈)N | 1.5 | (Al₆₀Cr₂₇V₅B₈)N, (Ti₆₂Cr₁₅Si₂₃) N | 1.5 | (Al₆₀Cr₂₇V₅B₈) N | 0.3 | 0.046 | Example |
| 7 | TiN | 0.3 | (Al₅₅Cr₃₅V₅B₅)N | 1.5 | (Al₅₅Cr₃₅V₅B₅)N, (Ti₇₀Cr₂₂Si₈) N | 1.8 | - | - | 0.042 | Example |
| 8 | CrN | 0.2 | (Al₅₅Cr₃₅V₅B₅)N | 1.5 | (Al₅₅Cr₃₅V₅B₅)N, (Ti₇₀Cr₂₂Si₈) N | 1.8 | - | - | 0.072 | Example |
| 9 | TiCN | 0.4 | (Al₆₀Cr₂₇V₅B₈)N | 1.5 | (Al₆₀Cr₂₇V₅B₈)N, (Ti₆₂Cr₁₅Si₂₃) N | 1.5 | - | - | 0.058 | Example |
| 10 | CrCN | 0.4 | (Al₅₅Cr₃₅V₅B₅)N | 1.5 | (Al₅₅Cr₃₅V₅B₅)N, (Ti₇₀Cr₂₂Si₈) N | 1.7 | - | - | 0.097 | Example |
| 11 | TiN | 0.3 | (Al₆₅Cr₃₅)N | 1.5 | (Al₆₅Cr₃₅)N, (Ti₈₀Si₂₀) N | 1.8 | - | - | 0.184 | Comparative example |
| 12 | TiCN | 1 | - | - | - | - | (Ti₈₀Si₂₀) N | 2.5 | 0.145 | Comparative example |
| 13 | TiCN | 3.5 | - | - | - | - | - | - | 0.264 | Comparative example |
| 14 | (Ti₅₀Al₅₀)N | 3.5 | - | - | - | - | - | - | 0.195 | Comparative example |

For the fourth film layers (TiCN) of Nos. 9, 12, and 13, the C content disposed directly on the base material was set to 0, i.e. TiN was used, and a film was formed while gradually increasing the C content toward the surface layer part. Also, for the fourth film layer (CrCN) of No. 10 , the C content disposed directly on the base material was set to 0, i.e. CrN was used, and a film was formed while gradually increasing the C content toward the surface layer part.

In the examples of Nos. 1 to 10, the multilayered film layer was observed using the cross section TEM method, and it was confirmed that 10 or more microcrystals of the second film layer were biting into the adjacent first film layer to a depth of 10% or more of the thickness of the first film layer in a surface area of 1 µm × 1 µm. In the comparative example of No. 11, it was unclear that microcrystals of the second film layer were biting into the adjacent first film layer when the multilayered film layer was observed using the cross section TEM method.

In TABLE 1, examples are shown together with the results of comparative examples in which hard films beyond the range of conventional hard films and the examples were subjected to a cutting test using an end mill coated using the same means.

It is apparent from TABLE 1 that the present examples have an abrasion width of the end mill flank that is reduced in comparison with the comparative examples, i.e., abrasion resistance is improved in relation to high hardness quenched steel.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A hard film for a cutting tool that is to be formed on a base material, wherein
the hard film has a multilayered film layer formed by alternately layering two or more layers each of a first film layer and a second film layer;
the first film layer is a film layer that contains at least Al and Cr as metal components, N as a non-metal component, and unavoidable impurities;
the second film layer is a film layer that contains at least Ti and Si as metal and semimetal components, N as a non-metal component, and unavoidable impurities;
the thickness of each of the first film layers and the second film layers is set to 1 nm or more and 20 nm or less; and
the second film layer has a mixed structure of an amorphous part and granular micro crystals having an average particle diameter of 1 nm or more and 20 nm or less, wherein
10 or more micro crystals of the second film layer penetrate into the adjacent first film layer to a depth of 10% or more of the thickness of the first film layer in an area of 1 µm × 1 µm when the multilayered film layer is observed using a cross section TEM method.

2. A hard film for a cutting tool that is to be formed on a base material, wherein
the hard film has a multilayered film layer formed by alternately layering two or more layers each of a first film layer and a second film layer;
the thickness of each layer of the first film layer and the second film layer is set to 1 nm or more and 20 nm or less;
the first film layer has metal and semimetal components that are expressed as Al_{(100-x-y-z)}Cr₍ₓ₎V_{(y)}B_{(z)} in terms of at%, wherein 20 ≤ x ≤ 40, 2 ≤ y ≤ 15, 2 ≤ z ≤ 15, and has N as a nonmetal component as well as unavoidable impurities; and
the second film layer has metal and semimetal components that are expressed as Ti_{(100-v-w)}Cr₍ᵥ₎Si_{(w)} in terms of at%, wherein 5 ≤ v ≤ 30, 5 ≤ w ≤ 30, and has N as a nonmetal component as well as unavoidable impurities.

3. The hard film according to claim 2, wherein
the second film layer has a mixed structure of an amorphous part and granular micro crystals having an average particle diameter of 1 nm or more and 20 nm or less, wherein
10 or more micro crystals of the second film layer penetrate into the adjacent first film layer to a depth of 10% or more of the thickness of the first film layer in an area of 1 µm × 1 µm when the multilayered film layer is observed using a cross section TEM method.

4. The hard film according to claim 1, wherein
a third film layer is disposed between the base material and the multilayered film layer; and
the metal component of the third film layer is the same as the metal component of the first film layer.

5. The hard film according to claim 2 or 3, wherein
a third film layer is disposed between the base material and the multilayered film layer;
the metal component and the semimetal component of the third film layer are the same as the metal component and the semimetal component of the first film layer.

6. The hard film according to claim 4 or 5, wherein
a fourth film layer is disposed directly on the base material;
the fourth film layer is composed of a nitride or a carbonitride, in which Ti is a main component; and
the thickness of the fourth film layer is set to 0.01 µm to 0.5 µm.

7. The hard film according to claim 4 or 5, wherein
a fourth film layer is disposed directly on the base material;
the fourth film layer is composed of a nitride or a carbonitride in which Cr is a main component; and
a thickness of the fourth film layer is set to 0.01 µm to 0.5 µm.

8. The hard film according to any one of claims 1 to 7, wherein
a fifth film layer is disposed on the surface layer side of the multilayered film layer; and
the metal component and the semimetal component of the fifth film layer are the same as the metal component and semimetal component of the second film layer.

9. The hard film according to any one of claims 1 to 7, wherein
a fifth film layer is disposed on the surface layer side of the multilayered film layer; and
the metal component, or the metal component and the semimetal component of the fifth film layer are the same as the metal component, or the metal component and semimetal component of the first film layer.

10. The hard film according to claim 8 or 9, wherein the base material is a superhard alloy composed of hard particles, in which WC is a main component, and a binding material having Co as a main component, wherein the average diameter of the WC particles is set to 0.1 µm to 2 µm, and the content of the Co is 5 to 15 wt%.
